# EUROPEAN PATENT APPLICATION

(11) **EP 2 487 723 A1**
(43) Date of publication of application: **15.08.2012**
(21) Application number: 10821951.0
(22) Date of filing: 04.10.2010
(51) Int. Cl.: H01L 31/04, H01L 31/042

(54) **WIRING SHEET, SOLAR BATTERY CELL WITH WIRING SHEET, SOLAR BATTERY MODULE, AND WIRING SHEET ROLL**

(30) Priority: 09.10.2009 JP 2009235123
(71) Applicant: Sharp Kabushiki Kaisha, Osaka-shi, Osaka 545-8522 (JP)
(72) Inventor: SAINOO, Yasushi, Osaka 545-8522 (JP); TSUNEMI, Akiko, Osaka 545-8522 (JP); NISHINA, Tomohiro, Osaka 545-8522 (JP)
(74) Representative: Müller-Boré & Partner Patentanwälte
(86) International application number: PCT/JP2010/067335
(87) International publication number: WO 2011/043281

(57) **Abstract**

Provided are an interconnection sheet (10), a solar cell with the interconnection sheet, and a solar cell module. In the interconnection sheet (10), a wire for p type (13) and a wire for n type (12) are disposed in a second direction (51) alternately one by one with a distance therebetween to configure an alternating array portion (20), and an outflow suppression portion (18) is provided outside the alternating array portion (20). Also provided are a solar cell with an interconnection sheet having a bonding layer (17) provided between a back electrode type solar cell (30) and the interconnection sheet (10), and the outflow suppression portion (18) provided outside the bonding layer (17), as well as a solar cell module using the solar cell with the interconnection sheet.

## Description

### TECHNICAL FIELD

The present invention relates to an interconnection sheet, a solar cell with the interconnection sheet, a solar cell module, and an interconnection sheet roll.

### BACKGROUND ART

In recent years, development of clean energy is demanded for global environmental issues such as depletion of energy resources, increase of CO₂ in the atmosphere, and the like, and in particular, solar photovoltaic power generation employing solar cell modules are developed, put to practical use and advanced as a new energy resource.

As a solar cell which configures such a solar cell module, a bifacial electrode type solar cell, which has for example a monocrystalline or polycrystalline silicon substrate having a photoreceptive surface with an impurity of a conductivity type opposite to that of the silicon substrate diffused therein to provide a pn junction, and a back surface opposite to the photoreceptive surface, with the surfaces provided with electrodes, respectively, has conventionally been the mainstream. Furthermore, in recent years, a solar cell having a silicon substrate having a back surface with both an electrode for p type and an electrode for n type, i.e., a so called back electrode type solar cell, is also being developed.

For example, Patent Literature 1 (Japanese Patent Laying-Open No. 2009-88145) describes a solar cell module having an interconnection substrate with an electrically conductive wiring patterned on a surface of an insulating substrate, and a back electrode type solar cell disposed on the interconnection substrate.

The solar cell module described in Patent Literature 1 has a configuration in which a solar cell obtained by electrically connecting the wiring of the interconnection substrate with an electrode of the back electrode type solar cell, and bonding the interconnection substrate and the back electrode type solar cell using an adhesive is sealed in a sealing material.

It is described that, in the solar cell module described in Patent Literature 1, the interconnection substrate and the back electrode type solar cell are fixed using the adhesive, which can suppress displacement of a connection position between the interconnection substrate and the back electrode type solar cell until fabrication of the solar cell module is completed (Patent Literature 1, paragraph [0040]).

It is also described that it is preferable to use an adhesive which has adhesiveness even in a heated state and also has stable adhesiveness even after being heated (Patent Literature 1, paragraph [0044]).

### CITATION LIST

### PATENT LITERATURE

PTL 1: Japanese Patent Laying-Open No. 2009-88145

### SUMMARY OF INVENTION

### TECHNICAL PROBLEM

Generally, however, an uncured adhesive has a property that, at high temperature, it easily flows due to a reduction in viscosity.

Therefore, there has been a problem that the adhesive provided between the interconnection substrate and the back electrode type solar cell flows out due to heating when the solar cell having the interconnection substrate and the back electrode type solar cell bonded using the adhesive is sealed in the sealing member.

There has been another problem that such outflow of the adhesive causes a decrease in a bonded area between the interconnection substrate and the back electrode type solar cell, and a reduction in bond strength between the interconnection substrate and the back electrode type solar cell.

Further, there has also been a problem that, if the adhesive is less filled at the periphery of the back electrode type solar cell, moisture enters between the back electrode type solar cell and the interconnection substrate, causing current leakage.

In view of the above-mentioned circumstance, one object of the present invention is to provide an interconnection sheet, a solar cell with the interconnection sheet, a solar cell module, and an interconnection sheet roll that can suppress a reduction in the reliability of the solar cell module.

### SOLUTION TO PROBLEM

The present invention is an interconnection sheet for connecting a back electrode type solar cell having a semiconductor substrate and an electrode for p type and an electrode for n type disposed at one surface of the semiconductor substrate, including: an insulating base material; and a wiring provided on a surface of the insulating base material, the wiring having a plurality of strip-shaped wires for p type each for connecting an electrode for p type of the back electrode type solar cell, a plurality of strip-shaped wires for n type each for connecting an electrode for n type of the back electrode type solar cell, a first connecting wire electrically connected to one end of each of the wires for p type, and a second connecting wire electrically connected to one end of each of the electrodes for n type, the wire for p type and the wire for n type each extending in a first direction, the first connecting wire and the second connecting wire each extending in a second direction different from the first direction, the wire for p type and the wire for n type being alternately disposed in the second direction with a distance therebetween to configure an alternating array portion, an outflow suppression portion being provided outside the alternating array portion.

Herein, in the interconnection sheet in accordance with the present invention, the outflow suppression portion may be formed of a wiring material configuring the wire for p type, the wire for n type, the first connecting wire, and the second connecting wire. Herein, the outflow suppression portion may be coupled to the first connecting wire or the second connecting wire.

Furthermore, the present invention is an interconnection sheet for connecting a back electrode type solar cell having a semiconductor substrate and an electrode for p type and an electrode for n type disposed at one surface of the semiconductor substrate, including: an insulating base material; and a wiring provided on a surface of the insulating base material, the wiring having a plurality of strip-shaped wires for p type each for connecting an electrode for p type of the back electrode type solar cell, a plurality of strip-shaped wires for n type each for connecting an electrode for n type of the back electrode type solar cell, a first connecting wire electrically connected to one end of each of the wires for p type, and a second connecting wire electrically connected to one end of each of the electrodes for n type, the wire for p type and the wire for n type each extending in a first direction, the first connecting wire and the second connecting wire each extending in a second direction different from the first direction, the wire for p type and the wire for n type being alternately disposed in the second direction with a distance therebetween to configure an alternating array portion, a convex portion protruding at a side provided with the wiring being provided outside the alternating array portion.

Furthermore, the present invention is a solar cell with an interconnection sheet, including: the above interconnection sheet; and a back electrode type solar cell having a semiconductor substrate and an electrode for p type and an electrode for n type disposed at one surface of the semiconductor substrate, the wire for p type of the interconnection sheet and the electrode for p type of the back electrode type solar cell being electrically connected to each other, the wire for n type of the interconnection sheet and the electrode for n type of the back electrode type solar cell being electrically connected to each other.

Furthermore, the present invention is an interconnection sheet roll including the above interconnection sheet that is rolled.

Furthermore, the present invention is a solar cell with an interconnection sheet, including: a back electrode type solar cell having a semiconductor substrate and an electrode disposed at one surface of the semiconductor substrate; and an interconnection sheet having an insulating base material and a wiring disposed at one surface of the insulating base material, the electrode of the back electrode type solar cell and the wiring of the interconnection sheet being electrically connected to each other, a bonding layer being provided between the back electrode type solar cell and the interconnection sheet, an outflow suppression portion being provided outside the bonding layer.

Furthermore, the present invention is a solar cell module including the solar cell with the interconnection sheet as described above.

### ADVANTAGEOUS EFFECTS OF INVENTION

The present invention can provide an interconnection sheet, a solar cell with the interconnection sheet, a solar cell module, and an interconnection sheet roll that can suppress a reduction in the reliability of the solar cell module.

### BRIEF DESCRIPTION OF DRAWINGS

Fig. 1 is a schematic plan view of one example of an interconnection sheet in accordance with the present invention, as seen at a side thereof provided with wiring.
Fig. 2 is a schematic enlarged plan view of the interconnection sheet shown in Fig. 1.
Fig. 3 is a schematic cross section taken along a line III-III in Fig. 2.
Fig. 4 is a schematic perspective view of one example of an interconnection sheet roll in accordance with the present invention.
Fig. 5 is a schematic side view for illustrating one example of how the present interconnection sheet roll is used.
Fig. 6 is a schematic plan view of one example of a back surface of a back electrode type solar cell used in the present invention.
Fig. 7 is a schematic cross section taken along a line VII-VII in Fig. 6.
Fig. 8 is a schematic plan view of one example of a solar cell with an interconnection sheet in accordance with the present invention, as seen at its photoreceptive surface.
Fig. 9 is a schematic cross section taken along a line IX-IX in Fig. 8.
Figs. 10(a) and 10(b) are schematic cross sections for illustrating one example of a method for manufacturing the solar cell with the interconnection sheet configured as shown in Figs. 8 and 9.
Fig. 11 is a schematic enlarged plan view for illustrating one example of a function of an outflow suppression portion in fabricating the solar cell with the interconnection sheet configured as shown in Figs. 8 and 9.
Figs. 12(a) and 12(b) are schematic cross sections for illustrating one example of a method for manufacturing a solar cell module in accordance with the present invention.
Figs. 13(a) and 13(b) are schematic cross sections for illustrating another example of the method for manufacturing the solar cell module in accordance with the present invention.
Fig. 14(a) is a schematic plan view of another example of the back surface of the back electrode type solar cell used in the present invention, and Fig. 14(b) is a schematic side view of the back electrode type solar cell shown in Fig. 14(a).
Fig. 15(a) is a schematic plan view of another example of the back surface of the back electrode type solar cell used in the present invention, and Fig. 15(b) is a schematic side view of the back electrode type solar cell shown in Fig. 15(a).
Fig. 16(a) is a schematic plan view of one example of the interconnection sheet in accordance with the present invention, as seen at a side thereof provided with wiring, and Fig. 16(b) is a schematic cross section taken along a line XVIb-XVIb in Fig. 16(a).

### DESCRIPTION OF EMBODIMENTS

Hereinafter, the present invention will be described in embodiments. In the figures, identical reference characters denote identical or corresponding components.

### <Interconnection Sheet>

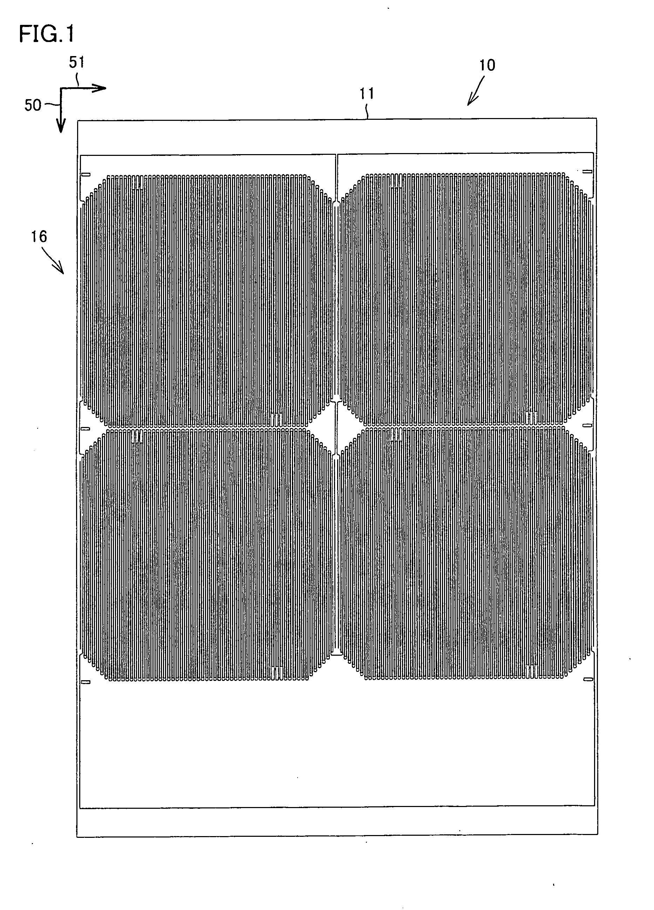

Fig. 1 is a schematic plan view of one example of an interconnection sheet in accordance with the present invention, as seen at a side thereof provided with wiring. As shown in Fig. 1, an interconnection sheet 10 has an insulating base material 11 and a wiring 16 provided on a surface of insulating base material 11.

Note that while in the present specification an example will be described with a first direction 50 and a second direction 51 forming 90°, the present invention only requires first direction 50 and second direction 51 to be different directions, respectively, and first direction 50 and second direction 51 may form an angle for example within a range of 90° ± 14°. Furthermore, in the present specification, first direction 50 and second direction 51 each include any directions identical and opposite to those shown in the figures and both, and can be used as appropriate depending on the situation.

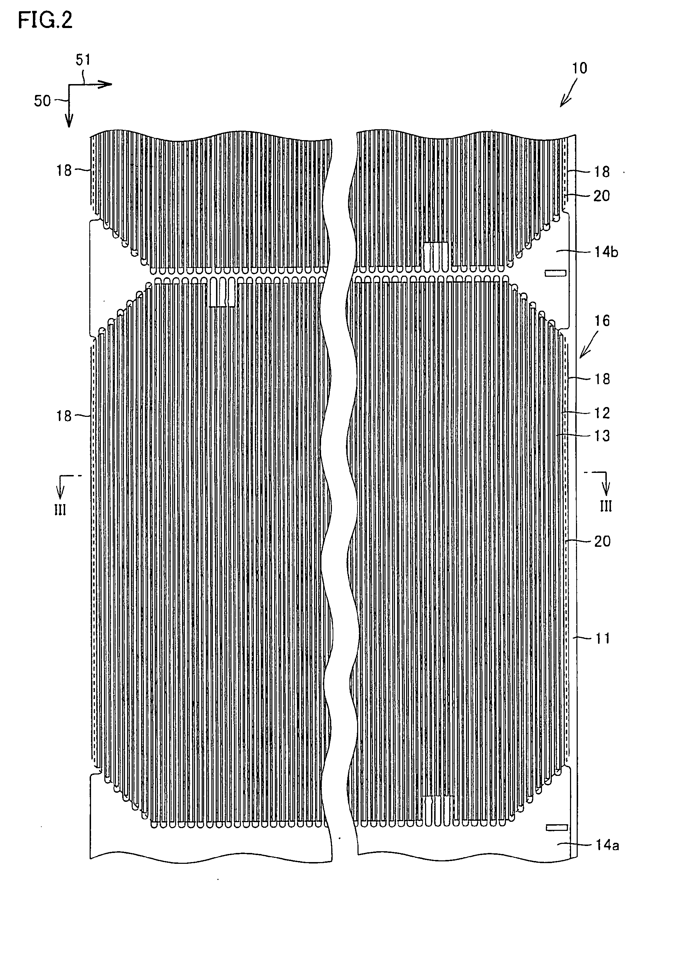

Fig. 2 is a schematic enlarged plan view of the interconnection sheet shown in Fig. 1. As shown in Fig. 2, wiring 16 of interconnection sheet 10 includes a wire for n type 12, a wire for p type 13, a first connecting wire 14a, and a second connecting wire 14b, disposed on the surface of insulating base material 11.

Note that wire for n type 12, wire for p type 13, first connecting wire 14a, and second connecting wire 14b are all electrically conductive, and wire for n type 12 and wire for p type 13 are each provided in the form of a strip extending in first direction 50, and first connecting wire 14a and second connecting wire 14b are each provided in a form extending in second direction 51.

A plurality of wires for n type 12 each have one end electrically connected to first connecting wire 14a, and a plurality of wires for p type 13 each have one end electrically connected to second connecting wire 14b.

A single first connecting wire 14a and the plurality of strip-shaped wires for n type 12 electrically connected thereto configure a single comb-like electrode for n type, and a single second connecting wire 14b and the plurality of strip-shaped wires for p type 13 electrically connected thereto configure a single comb-like electrode for p type.

Herein, the single comb-like electrode for p type and the single comb-like electrode for n type are provided to have their respective teeth facing each other, and strip-shaped wires for n type 12 corresponding to the teeth of the comb-like electrode for n type and strip-shaped wires for p type 13 corresponding to the teeth of the comb-like electrode for p type are disposed in second direction 51 one by one alternately with a distance therebetween to configure an alternating array portion 20. Note that alternating array portion 20 is a wiring area where wires for n type 12 and wires for p type 13 are disposed one by one alternately.

Furthermore, one end of second connecting wire 14b in first direction 50 is electrically connected to one end of each of the plurality of wires for p type 13, and the other end of second connecting wire 14b in first direction 50 is electrically connected to one end of each of the plurality of wires for n type 12. Thus, alternating array portions 20 disposed adjacently in first direction 50 are electrically connected by second connecting wire 14b.

Furthermore, as shown in Fig. 1, interconnection sheet 10 has an upper left alternating array portion and a lower left alternating array portion electrically connected together, the lower left alternating array portion and a lower right alternating array portion electrically connected together, and the lower right alternating array portion and an upper right alternating array portion electrically connected together. Thus, interconnection sheet 10 shown in Fig. 1 has alternating array portions electrically connected in the form of the letter U.

Herein, in the example shown in Fig. 2, outflow suppression portions 18 are provided at both sides in second direction 51 of alternating array portions 20 on insulating base material 11 of interconnection sheet 10, each with a predetermined distance from alternating array portion 20.

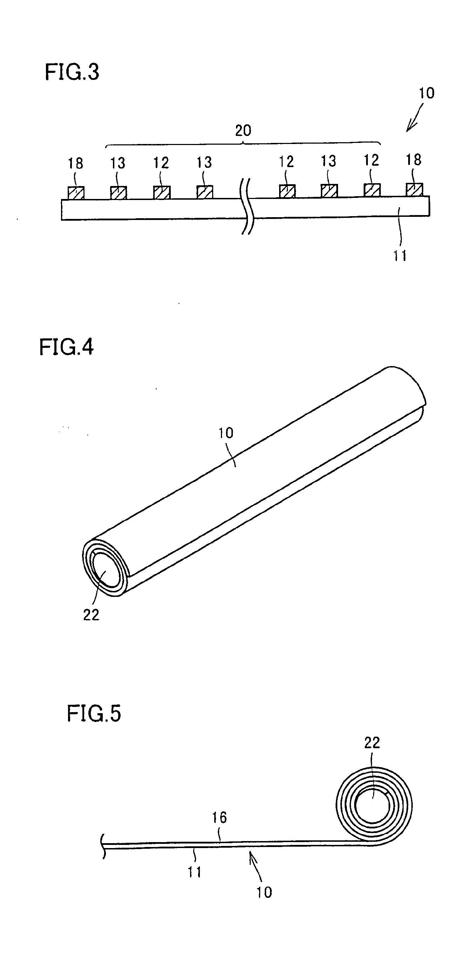

Fig. 3 is a schematic cross section taken along a line III-III in Fig. 2. As shown in Fig. 3, interconnection sheet 10 has wire for n type 12 and wire for p type 13 only on one surface of insulating base material 11, and wire for n type 12 and wire for p type 13 are disposed alternately one by one with a predetermined distance therebetween to configure alternating array portion 20. Outflow suppression portions 18 are formed at both outer sides of alternating array portions 20, each in the shape of a convex portion protruding from the surface of insulating base material 11 at the side provided with wire for n type 12 and wire for p type 13.

By providing outflow suppression portion 18 configured as described above, outflow of an insulating resin or the like used to bond interconnection sheet 10 and a back electrode type solar cell can be blocked by outflow suppression portion 18, as described later.

Note that while the present embodiment describes a case where outflow suppression portion 18 has a surface shape in the form of a straight line extending in first direction 50, the surface shape of outflow suppression portion 18 is not limited thereto, and may be for example in the form of a broken line extending in first direction 50, a semicircle, a triangle, or the like.

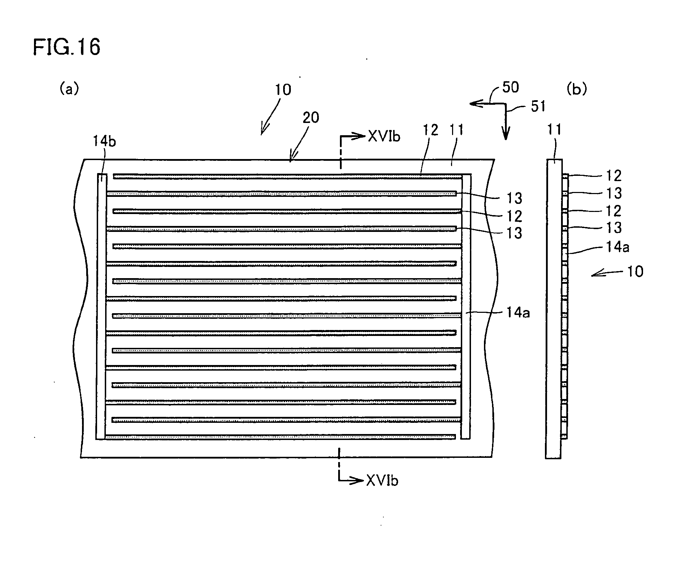

Fig. 16(a) is a schematic plan view of one example of the interconnection sheet in accordance with the present invention, as seen at a side thereof provided with wiring, and Fig. 16(b) is a schematic cross section taken along a line XVIb-XVIb in Fig. 16(a).

This example also provides wire for n type 12 and wire for p type 13 each in the form of a strip extending in first direction 50, and first connecting wire 14a and second connecting wire 14b each in a form extending in second direction 51. A plurality of wires for n type 12 each have one end electrically connected to first connecting wire 14a, and a plurality of wires for p type 13 each have one end electrically connected to second connecting wire 14b. Note that Figs. 16(a) and 16(b) do not show outflow suppression portion 18 for convenience of description.

A single first connecting wire 14a and the plurality of strip-shaped wires for n type 12 electrically connected thereto configure a single comb-like wiring for n type, and a single second connecting wire 14b and the plurality of strip-shaped wires for p type 13 electrically connected thereto configure a single comb-like wiring for p type.

Herein, the single comb-like wiring for n type and the single comb-like wiring for p type are provided to have their respective teeth facing each other, and strip-shaped wires for n type 12 corresponding to the teeth of the comb-like wiring for n type and strip-shaped wires for p type 13 corresponding to the teeth of the comb-like wiring for p type are disposed in second direction 51 one by one alternately with a distance therebetween to configure alternating array portion 20.

Note that strip-shaped wire for n type 12 and/or strip-shaped wire for p type 13 may have a surface having at least a portion in the form of a triangle and/or a trapezoid.

Furthermore, in the present invention, the concept of "a wire for n type and a wire for p type alternately disposed" includes not only a concept that the wire for n type and the wire for p type are alternately disposed one by one, but also a concept that between adjacent wires for n type a plurality of wires for p type are disposed, and a concept that between adjacent wires for p type a plurality of wires for n type are disposed.

Furthermore, in the above description, insulating base material 11 may be formed of any material that is electrically insulating, and it may be formed for example of a material including at least one type of resin selected from the group consisting of polyethylene terephthalate (PET), polyethylene naphthalate (PEN), polyphenylene sulfide (PPS), polyvinyl fluoride (PVF), and polyimide.

Furthermore, insulating base material 11 may not be limited to any particular value in thickness, and may range for example from 25 µm to 150 µm.

Note that insulating base material 11 may be formed of a single layer, i.e., have a monolayer structure, or may be formed of two or more layers, i.e., have a multilayer structure.

Furthermore, wiring 16 may be formed of any material that is electrically conductive, e.g., metal including at least one type selected from the group consisting of copper, aluminum, and silver.

Furthermore, wiring 16 is also not limited in thickness, and may range for example from 10 µm to 50 µm. In addition, the thickness of outflow suppression portion 18 can also be set as appropriate.

Although it is preferable from the viewpoint of simplifying a manufacturing process that outflow suppression portion 18 is formed of the same material as that of wiring 16, the material for outflow suppression portion 18 is not limited thereto, and outflow suppression portion 18 may be formed of a material identical to or different from that of wiring 16. Further, outflow suppression portion 18 may be formed by deforming a portion of insulating base material 11.

Herein, in a case where outflow suppression portion 18 is formed of an electrically conductive substance, outflow suppression portion 18 may be electrically connected to either first connecting wire 14a or second connecting wire 14b, and may not be electrically connected to both of first connecting wire 14a and second connecting wire 14b.

Furthermore, in a case where outflow suppression portion 18 is formed of an electrically insulating material, outflow suppression portion 18 may be coupled to at least one of first connecting wire 14a and second connecting wire 14b, and may not be coupled to both of first connecting wire 14a and second connecting wire 14b.

Furthermore, wiring 16 may have a surface having at least a portion provided for example with an electrically conductive substance including at least one type selected from the group consisting of nickel (Ni), gold (Au), platinum (Pt), palladium (Pd), silver (Ag), tin (Sn), SnPb solder, and indium tin oxide (ITO). This provides a tendency that electrical connection between wiring 16 of interconnection sheet 10 and an electrode of a back electrode type solar cell described later can be excellent and weather resistance of wiring 16 can be improved. It is needless to say that outflow suppression portion 18 may also have a surface having at least a portion provided with the electrically conductive substance described above.

Furthermore, wiring 16 and/or outflow suppression portion 18 may have a surface having at least a portion subjected to rust-proofing, blackening processing, or similar surface processing.

Note that wiring 16 and outflow suppression portion 18 may each be formed of a single layer, i.e., have a monolayer structure, or may be formed of two or more layers, i.e., have a multilayer structure.

Hereinafter will be described one example of a method for manufacturing interconnection sheet 10 in the above configuration. Initially, insulating base material 11 for example of a PEN film is prepared, and an electrically conductive substance for example in the form of metal foil, metal plate or the like is affixed across one surface of insulating base material 11. This can be done for example by pulling out a roll of the insulating base material cut to have a predetermined width, applying an adhesive to one surface of the insulating base material, disposing thereon a roll of metallic foil cut to be slightly smaller than the width of the insulating base material, and pressurizing and heating them to bond them together.

Subsequently, the electrically conductive substance affixed on the surface of insulating base material 11 is partially, photolithographically or similarly etched away and thus patterned to provide wiring 16 including wire for n type 12, wire for p type 13, first connecting wire 14a, and second connecting wire 14b, as well as outflow suppression portion 18, formed of the patterned electrically conductive substance, on the surface of insulating base material 11. Interconnection sheet 10 configured as described above can thus be fabricated.

Note that outflow suppression portion 18 is preferably formed of the same material as the wiring material (electrically conductive substance) configuring each of wire for n type 12, wire for p type 13, first connecting wire 14a, and second connecting wire 14b. In this case, not only wiring 16 including wire for n type 12, wire for p type 13, first connecting wire 14a, and second connecting wire 14b but also outflow suppression portion 18 can be formed by patterning the wiring material on insulating base material 11, facilitating formation of outflow suppression portion 18.

Furthermore, in a case where outflow suppression portion 18 is formed to be coupled to first connecting wire 14a and/or second connecting wire 14b, since outflow suppression portion 18 is coupled to first connecting wire 14a and/or second connecting wire 14b, the coupled portion has a closed shape. Thus, outflow of an insulating resin or the like used to bond interconnection sheet 10 and a back electrode type solar cell can be blocked more effectively by outflow suppression portion 18.

### <Interconnection Sheet Roll>

Fig. 4 is a schematic perspective view of one example of an interconnection sheet roll in accordance with the present invention. The interconnection sheet roll is formed as follows: for example, wiring 16 of the form shown in Fig. 1 is successively formed on a surface of insulating base material 11 to form an elongate interconnection sheet 10 which is in turn rolled on a core 22. Note that core 22 may be any core that allows interconnection sheet 10 to be rolled thereon.

Interconnection sheet 10 thus rolled to be an interconnection sheet roll can be unrolled from and cut off the interconnection sheet roll to have different lengths, as required, as shown in the schematic side view of Fig. 5, and thus used, and the same single interconnection sheet roll can thus be used to fabricate solar cells with a interconnection sheet and solar cell modules of various sizes.

For example, if interconnection sheet 10 shown in Fig. 1 unrolled from the interconnection sheet roll in first direction 50 is cut in second direction 51 across alternating array portion 20 and thus has opposite ends configured of alternating array portions 20 cut across, then, for example, attaching a single strip-shaped conductive member to one end of cut-out interconnection sheet 10 at two cut-across alternating array portions 20 such that the conductive member has its longitudinal direction matched to second direction 51 allows the cut-out interconnection sheet to be used as interconnection sheet 10. This can electrically connect wires for n type 12 and wires for p type 13 of two alternating array portions 20 located at one end of the cut-out interconnection sheet 10 that are aligned in second direction 51, and hence electrically connect these two alternating array portions 20 adjacent in second direction 51 to allow interconnection sheet 10 to have alternating array portions 20 electrically connected in the form of the letter U.

### <Back Electrode Type Solar Cell>

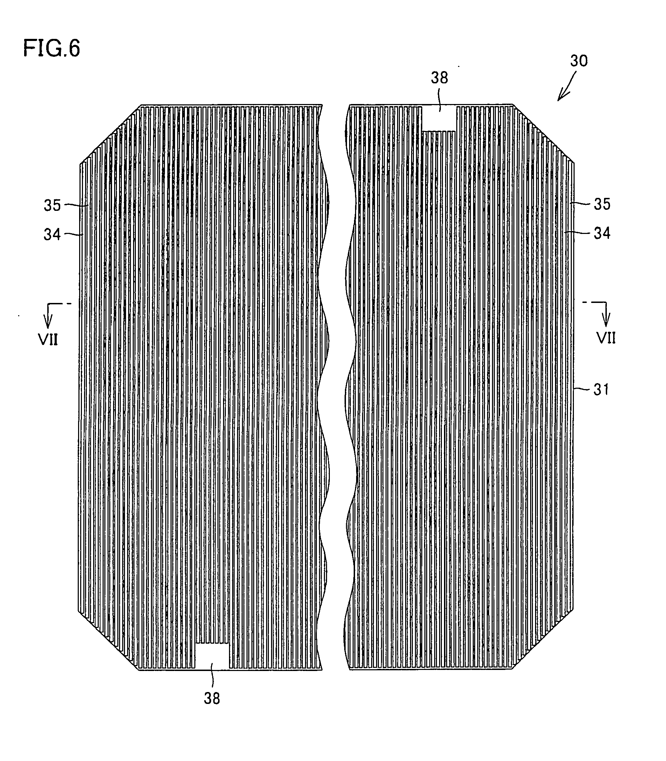

Fig. 6 is a schematic plan view of one example of a back surface of a back electrode type solar cell used in the present invention. Herein, a back electrode type solar cell 30 has an electrode for n type 34 and an electrode for p type 35 each in the form of a strip, and strip-shaped electrode for n type 34 and strip-shaped electrode for p type 35 are disposed on a back surface of a semiconductor substrate 31 one by one alternately with a predetermined distance therebetween.

Furthermore, back electrode type solar cell 30 has a perimeter partially provided with an electrode-absent portion 38 that does not have electrode for n type 34 and electrode for p type 35. Electrode-absent portion 38 can be provided for example as an alignment mark for providing back electrode type solar cell 30 on interconnection sheet 10 at a position precisely, a mark indicating an orientation of back electrode type solar cell 30, a symbol indicating manufacturing information of back electrode type solar cell 30, or a symbol indicating property information of back electrode type solar cell 30.

Note that electrode for n type 34 and electrode for p type 35 on the back surface of back electrode type solar cell 30 are not limited geometrically or positionally to the configuration shown in Fig. 6, as long as they are electrically connectable to wire for n type 12 and wire for p type 13 of interconnection sheet 10.

Furthermore, on at least a portion of a surface of electrode for n type 34 and/or at least a portion of a surface of electrode for p type 35 of back electrode type solar cell 30, for example, an electrically conductive substance including at least one type selected from the group consisting of nickel (Ni), gold (Au), platinum (Pt), palladium (Pd), silver (Ag), copper (Cu), tin (Sn), titanium (Ti), SnPb solder, SnBi solder, and indium tin oxide (ITO) may be provided. This provides a tendency that electrical connection between wiring 16 (wire for n type 12 and wire for p type 13) of interconnection sheet 10 and an electrode (electrode for n type 34 and electrode for p type 35) of back electrode type solar cell 30 can be excellent and weather resistance of the electrode (electrode for n type 34 and electrode for p type 35) of back electrode type solar cell 30 can be improved.

Furthermore, at least a portion of the surface of electrode for n type 34 and/or at least a portion of the surface of electrode for p type 35 of back electrode type solar cell 30 may be subjected for example to rust-proofing or similar surface processing.

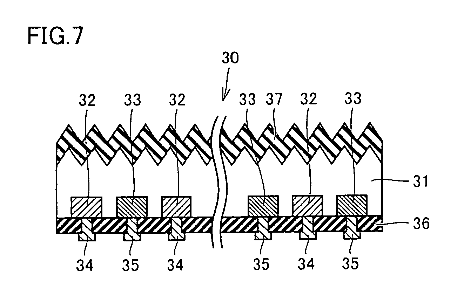

Fig. 7 is a schematic cross section taken along a line VII-VII in Fig. 6. Herein, back electrode type solar cell 30 for example has an n or p type silicon substrate or similar semiconductor substrate 31, an anti-reflection film 37 provided on an uneven surface side of semiconductor substrate 31 serving as a photoreceptive surface of back electrode type solar cell 30, and a passivation film 36 provided on a back surface side of semiconductor substrate 31 serving as the back surface of back electrode type solar cell 30.

Furthermore, semiconductor substrate 31 at the back surface side has for example phosphorus or a similar n type impurity and boron or a similar p type impurity diffused therein to have an n type impurity diffusion region 32 and a p type impurity diffusion region 33, respectively, alternately with a predetermined distance therebetween, and is also provided with electrode for n type 34 and electrode for p type 35 in contact with n type impurity diffusion region 32 and p type impurity diffusion region 33, respectively, via contact holes provided through passivation film 36 provided on the back surface side of semiconductor substrate 31.

Furthermore, semiconductor substrate 31 of n or p type conduction will have a back surface side having a plurality of pn junctions each formed at an interface of n type impurity diffusion region 32 or p type impurity diffusion region 33 and an internal portion of semiconductor substrate 31. Whichever of n type conduction or p type conduction semiconductor substrate 31 may be of, n type impurity diffusion region 32 and p type impurity diffusion region 33 each have junction with the internal portion of semiconductor substrate 31, and accordingly electrode for n type 34 and electrode for p type 35 will serve as electrodes corresponding respectively to the plurality of pn junctions provided closer to the back surface side of semiconductor substrate 31.

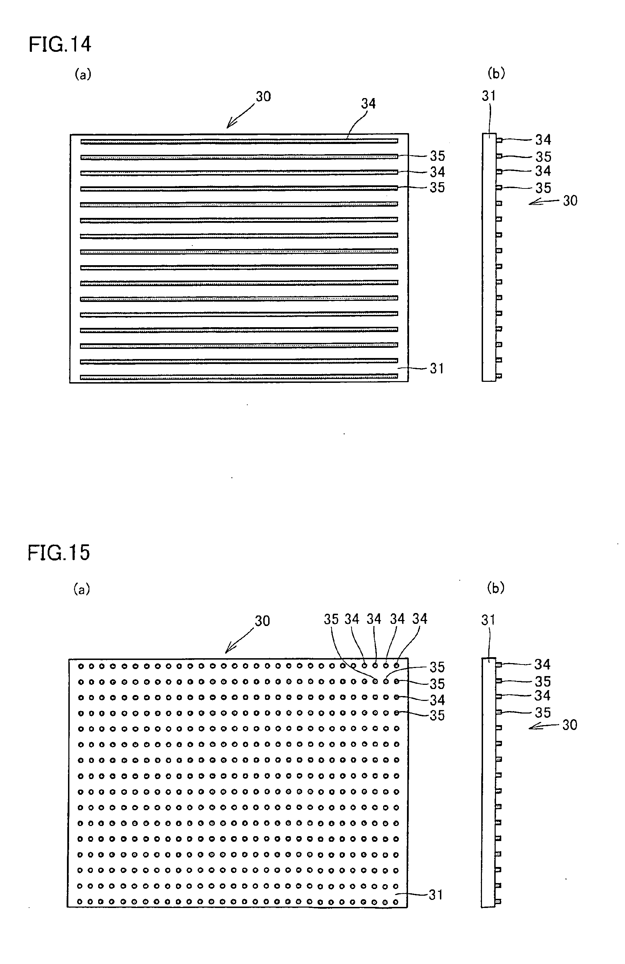

Fig. 14(a) is a schematic plan view of another example of the back surface of the back electrode type solar cell used in the present invention, and Fig. 14(b) is a schematic side view of the back electrode type solar cell shown in Fig. 14(a).

This example also provides electrode for n type 34 and electrode for p type 35 each provided in the form of a strip and disposed on semiconductor substrate 31 one by one alternately with a predetermined distance therebetween.

Note that strip-shaped electrode for n type 34 and/or strip-shaped electrode for p type 35 may have a surface having at least a portion in the form of a triangle and/or a trapezoid.

Furthermore, in the present invention, the concept of "an electrode for n type and an electrode for p type alternately disposed" includes not only a concept that the electrode for n type and the electrode for p type are alternately disposed one by one, but also a concept that between adjacent electrodes for n type a plurality of electrodes for p type are disposed, and a concept that between adjacent electrodes for p type a plurality of electrodes for n type are disposed.

Fig. 15(a) is a schematic plan view of another example of the back surface of the back electrode type solar cell used in the present invention, and Fig. 15(b) is a schematic side view of the back electrode type solar cell shown in Fig. 15(a).

In this example, electrode for n type 34 and electrode for p type 35 are formed in dots, respectively, and a plurality of dot electrodes for n type 34 and a plurality of dot electrodes for p type 35 are each disposed linearly. The plurality of dot electrodes for n type 34 and the plurality of dot electrodes for p type 35 form rows, respectively, and the rows are disposed alternately one by one with a distance therebetween.

Note that the concept of "being linearly disposed" only requires being disposed to proceed at least in a direction, and it includes not only a case with electrodes for n type and/or electrodes for p type disposed exactly in a line(s), but also a case with at least a portion thereof disposed in a zigzag manner. Furthermore, the distances between the electrodes for n type in a row of a plurality of electrodes for n type and/or the distances between the electrodes for p type in a row of a plurality of electrodes for p type may not be equal.

Furthermore, the concept of "a plurality of electrodes for n type and a plurality of electrodes for p type forming rows, respectively, alternately disposed" includes not only a concept that a row of the plurality of electrodes for n type and a row of the plurality of electrodes for p type, respectively, are alternately disposed one by one, but also a concept that between adjacent rows of electrodes for n type a plurality of rows of electrodes for p type are disposed, and a concept that between adjacent rows of electrodes for p type a plurality of rows of electrodes for n type are disposed.

As semiconductor substrate 31, a silicon substrate formed of an n or p type polycrystalline or monocrystalline silicon and the like can be implemented for example. Note that preferably, semiconductor substrate 31 is monocrystalline for forming a pn junction at the back surface side.

Electrode for n type 34 and electrode for p type 35 can be implemented for example as electrodes formed of metal such as silver.

As passivation film 36, for example, a silicon oxide film, a silicon nitride film, or a silicon oxide film and a silicon nitride film stacked in layers, or the like can be implemented.

As anti-reflection film 37, for example, a silicon nitride film can be implemented.

Note that the concept of the present back electrode type solar cell includes not only a back electrode type solar cell having semiconductor substrate 31 with only one surface (a back surface) having both electrode for n type 34 and electrode for p type 35, but also all of a metal wrap through (MWT) cell (i.e., a solar cell having a semiconductor substrate having a through hole with a portion of an electrode therein) and similar, so called back contact type solar cells (i.e., solar cells having a structure extracting an electric current from the cell's back surface opposite to its photoreceptive surface).

### <Solar Cell with Interconnection Sheet>

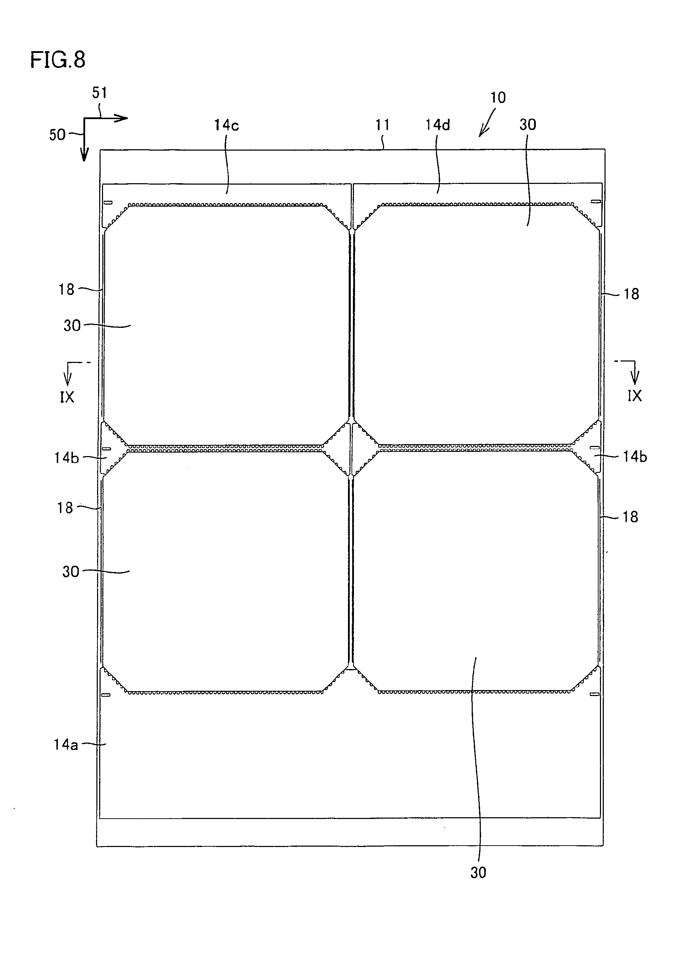

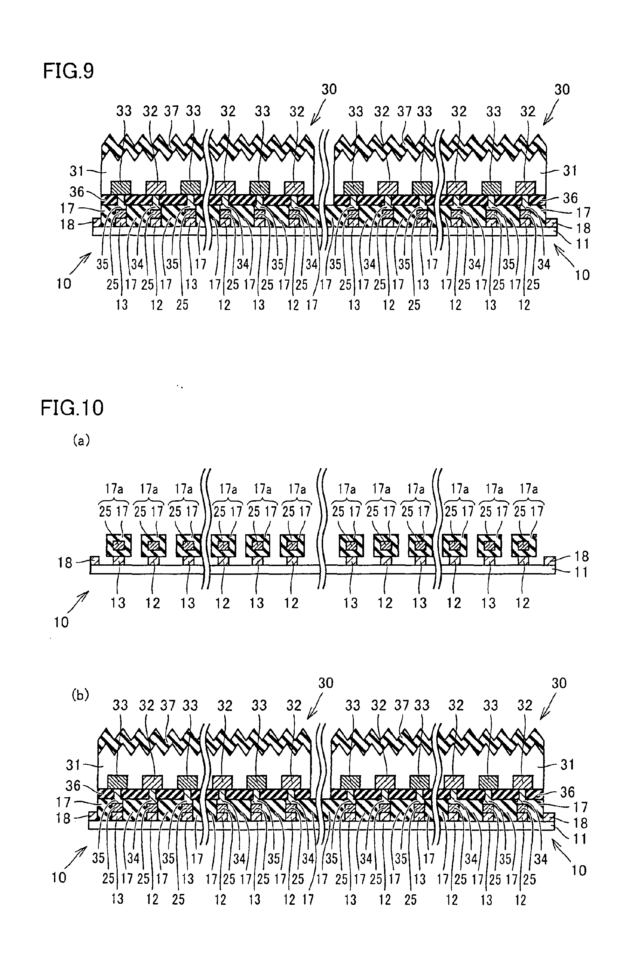

Fig. 8 is a schematic plan view of one example of a solar cell with an interconnection sheet in accordance with the present invention, as seen at its photoreceptive surface, and Fig. 9 is a schematic cross section taken along a line IX-IX in Fig. 8.

Note that hereinafter a solar cell with an interconnection sheet of the present invention will be described by way of example in a configuration in which a plurality of back electrode type solar cells 30 shown in Figs. 6 and 7 are connected on wiring 16 of interconnection sheet 10 shown in Figs. 1 to 3, however, the solar cell with the interconnection sheet of the present invention is not limited in configuration to that shown in Figs. 8 and 9. For example, the solar cell with the interconnection sheet of the present invention may be configured with a single interconnection sheet with a single back electrode type solar cell connected thereto.

As shown in Figs. 8 and 9, the solar cell with the interconnection sheet is fabricated by disposing back electrode type solar cell 30 on interconnection sheet 10 such that a back surface side of back electrode type solar cell 30 and the side of interconnection sheet 10 provided with wiring 16 face each other.

Herein, as shown in Fig. 9, electrode for n type 34 at the back surface side of back electrode type solar cell 30 is electrically connected to wire for n type 12 provided on a surface of insulating base material 11 of interconnection sheet 10 via an electrically conductive adhesive 25, and electrode for p type 35 at the back surface of back electrode type solar cell 30 is electrically connected to wire for p type 13 provided on the surface of insulating base material 11 of interconnection sheet 10 via electrically conductive adhesive 25.

Note that connecting wiring 16 of interconnection sheet 10 and an electrode of back electrode type solar cell 30 only requires connecting them so that they can electrically conduct with each other, and accordingly, it is not limited to electrically connecting them via conductive adhesive 25; for example, they may directly contact each other and thus be electrically connected to each other.

Then, an insulating resin 17 is provided between interconnection sheet 10 and back electrode type solar cell 30 in a region other than wiring 16 of interconnection sheet 10 and the electrodes of back electrode type solar cell 30. Insulating resin 17 thus introduced allows a solar cell with an interconnection sheet to have back electrode type solar cell 30 and interconnection sheet 10 firmly bonded together via insulating resin 17.

The solar cell with the interconnection sheet of the above configuration has interconnection sheet 10 with adjacent alternating array portions 20 electrically connected to each other, and will accordingly have adjacent back electrode type solar cells 30 on interconnection sheet 10 electrically connected in series.

That is, with reference to Fig. 8, upper left back electrode type solar cell 30 and lower left back electrode type solar cell 30 are electrically connected in series, lower left back electrode type solar cell 30 and lower right back electrode type solar cell 30 are electrically connected in series, and lower right back electrode type solar cell 30 and upper right back electrode type solar cell 30 are electrically connected in series. Thus, the solar cell with the interconnection sheet shown in Fig. 8 has back electrode type solar cells 30 electrically connected in series in the form of the letter U.

Back electrode type solar cell 30 receives light at the photoreceptive surface, and thereby generates an electric current, which is in turn extracted through electrode for n type 34 and electrode for p type 35 of back electrode type solar cell 30 to wire for n type 12 and wire for p type 13 of interconnection sheet 10. Wire for n type 12 and wire for p type 13 of interconnection sheet 10 receive the electric current, which is in turn extracted externally through terminals 14c, 14d of wiring 16 of interconnection sheet 10.

Hereinafter, reference will be made to Figs. 10(a) and 10(b) showing schematic cross sections to describe an example of a method for manufacturing the solar cell with the interconnection sheet of the configuration shown in Figs. 8 and 9.

Initially, as shown in Fig. 10(a), interconnection sheet 10 of the configuration shown in Figs. 1 to 3 is prepared, and a resin composition 17a containing electrically conductive adhesive 25 such as solder and insulating resin 17 is applied to a surface of wiring 16 of interconnection sheet 10. Herein, interconnection sheet 10 can for example be interconnection sheet 10 unrolled by a desired length from the interconnection sheet roll of the above-mentioned configuration and then cut off. Resin composition 17a may be applied to surfaces of the electrodes of back electrode type solar cell 30, or may be applied to both of a surface of wiring 16 of interconnection sheet 10 and surfaces of the electrodes of back electrode type solar cell 30.

Furthermore, an application method of resin composition 17a is not particularly limited, but for example, it may be screen printing, application with a dispenser, ink jet, or application with a slit coater or the like.

Furthermore, preferably, insulating resin 17 includes any of epoxy resin, acrylic resin, and a resin of a mixture of epoxy resin and acrylic resin. Note that, in the present invention, it is needless to say that insulating resin 17 is not limited to epoxy resin, acrylic resin, and a resin of a mixture of epoxy resin and acrylic resin.

Furthermore, resin composition 17a may include one or more types of conventionally known additives, such as a curing agent, as a component other than a resin component.

Then, as shown in Fig. 10(b), back electrode type solar cell 30 is provided on interconnection sheet 10 such that electrode for n type 34 of back electrode type solar cell 30 is positioned on wire for n type 12 of interconnection sheet 10 and electrode for p type 35 of back electrode type solar cell 30 is positioned on wire for p type 13 of interconnection sheet 10.

In doing so, resin composition 17a is heated and melted, and insulating resin 17 in resin composition 17a enters a region between a connection portion connecting electrode for n type 34 and wire for n type 12 and a connection portion connecting electrode for p type 35 and wire for p type 13, and thus introduced there, while electrically conductive adhesive 25 in resin composition 17a aggregates between electrode for n type 34 and wire for n type 12 and between electrode for p type 35 and wire for p type 13 and thus electrically connects them.

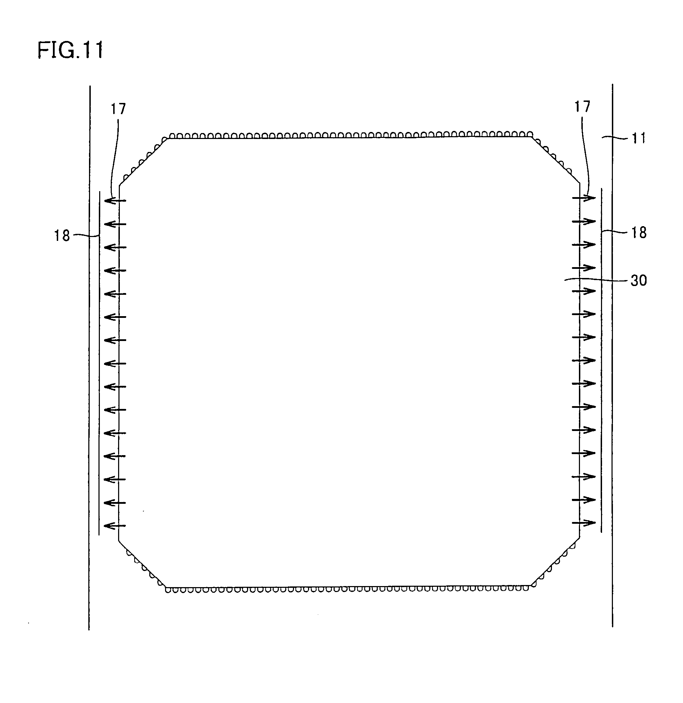

Herein, as shown in Fig. 2, outflow suppression portions 18 extending in first direction 50 are provided at outer sides in second direction 51 of alternating array portions 20 of interconnection sheet 10. Accordingly, as shown for example in a schematic enlarged plan view of Fig. 11, outflow of insulating resin 17 to the outside of interconnection sheet 10 can be blocked by outflow suppression portions 18.

This can suppress a reduction in bond strength between back electrode type solar cell 30 and interconnection sheet 10 caused by the outflow of insulating resin 17 in the vicinity of the periphery of the solar cell with the interconnection sheet, and thus effectively suppress a reduction in the reliability of a solar cell module due to the reduction in bond strength between back electrode type solar cell 30 and interconnection sheet 10 in the vicinity of the periphery of the solar cell module.

The solar cell with the interconnection sheet of the configuration shown in Figs. 8 and 9 is thus manufactured. Herein, the solar cell with the interconnection sheet has a configuration in which a bonding layer made of insulating resin 17 is provided between back electrode type solar cell 30 and interconnection sheet 10, and outflow suppression portions 18 are provided on surface regions of insulating base material 11 outside the bonding layer.

From the viewpoint of blocking the outflow of insulating resin 17 more reliably by outflow suppression portion 18, outflow suppression portion 18 preferably has at least one of the following configurations (1) to (3):
(1) At least a portion of outflow suppression portion 18 is provided on the surface of insulating base material 11 outside the bonding layer made of insulating resin 17, and the distance between outflow suppression portion 18 and back electrode type solar cell 30 is not more than 0.1 mm;
(2) At least a portion of outflow suppression portion 18 is present within a region between back electrode type solar cell 30 and insulating base material 11 of interconnection sheet 10; and
(3) The height at which at least a portion of outflow suppression portion 18 protrudes from the surface of insulating base material I 1 of interconnection sheet 10 at the side provided with wiring 16 is equal to or less than the height of the bonding layer made of insulating resin 17 between back electrode type solar cell 30 and insulating base material 11 of interconnection sheet 10.

Note that, in the above description, after back electrode type solar cell 30 is provided on interconnection sheet 10, for example insulating resin 17 may be heated and/or exposed to light or the like and thus cured.

When insulating resin 17 is cured, it will itself shrink, but because insulating resin 17 is bonded to passivation film 36 of back electrode type solar cell 30 and insulating base material 11 of interconnection sheet 10, it exerts shrinkage force to further firmly bond back electrode type solar cell 30 and interconnection sheet 10 together.

### <Solar Cell Module>

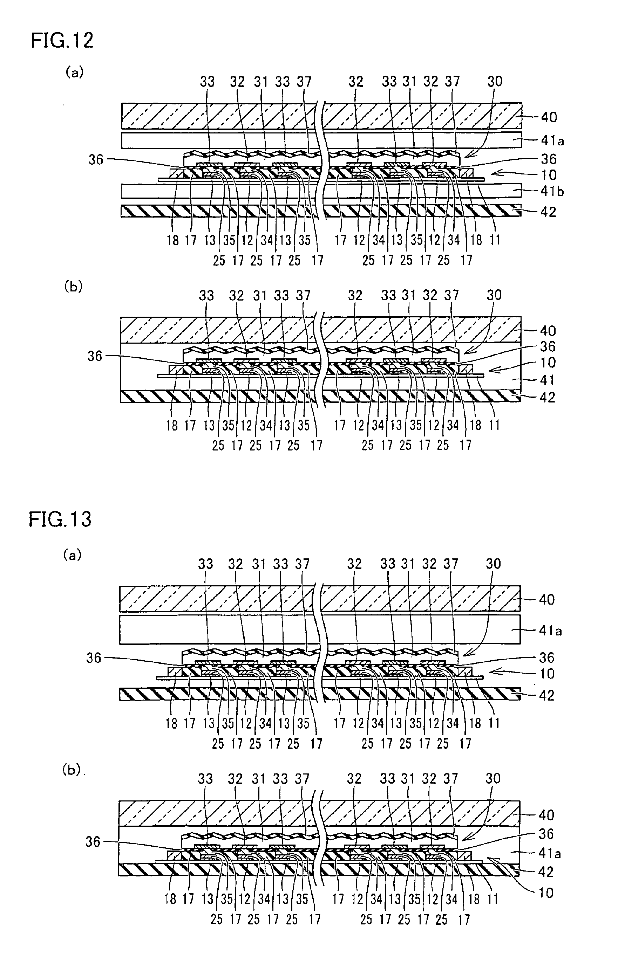

Figs. 12(a) and 12(b) are schematic cross sections for illustrating one example of a method for manufacturing a solar cell module in accordance with the present invention. Hereinafter, reference will be made to Figs. 12(a) and 12(b) to describe one example of the method for manufacturing the solar cell module in accordance with the present invention.

The following will describe as one example of the present solar cell module a solar cell module having sealed in a sealing material the solar cell with the interconnection sheet configured as shown in Figs. 8 and 9.

Initially, as shown in Fig. 12(a), a transparent substrate 40 with a first transparent resin 41 a in the form of a sheet is positioned closer to back electrode type solar cell 30 of the solar cell with the interconnection sheet shown in Figs. 8 and 9, and a back surface protection sheet 42 with a second transparent resin 41 b in the form of a sheet is positioned closer to interconnection sheet 10 of the solar cell with the interconnection sheet shown in Figs. 8 and 9.

Then, first transparent resin 41 a is pressed into contact with back electrode type solar cell 30 of the solar cell with the interconnection sheet, second transparent resin 41b is pressed into contact with interconnection sheet 10 of the solar cell with the interconnection sheet, and they thus undergo a heat treatment and are cured integrally. Thereby, as shown in Fig. 12(b), first transparent resin 41 a and second transparent resin 41b are integrated together to provide a sealing material 41 sealing the solar cell with the interconnection sheet, and one example of the present solar cell module is thus fabricated.

Note that the solar cell with the interconnection sheet can be sealed in sealing material 41 through press and a heat treatment for example using equipment referred to as a laminator performing vacuum press and a heat treatment. For example, the laminator is employed to thermally deform first transparent resin 41 a and second transparent resin 41 b and thermally set first transparent resin 41 a and second transparent resin 41 b to integrate the transparent resins together to provide sealing material 41 to encapsulate and thus seal the solar cell with the interconnection sheet therein to fabricate a solar cell module.

Herein, vacuum press is press performed in an atmosphere smaller in pressure than the atmospheric pressure. Furthermore, performing the press by vacuum press is preferable in that it provides a tendency that first transparent resin 41a and second transparent resin 41 b have less voids formed therebetween, and sealing material 41 formed of first transparent resin 41a and second transparent resin 41b integrated together has less gaseous voids remaining therein.

Note that transparent substrate 40 may be any substrate that is transparent to solar light, and it can for example be a glass substrate.

Furthermore, first transparent resin 41 a and second transparent resin 41 b may be any resin that is transparent to solar light, and inter alia, at least one type of transparent resin selected from the group consisting of ethylene vinyl acetate resin, epoxy resin, acrylic resin, urethane resin, olefin resin, polyester resin, silicone resin, polystyrene resin, polycarbonate resin, and rubber resin is preferable. In that case, sealing material 41 is excellent in weather resistance and enhanced in permeability for solar light, and can be fixed to transparent substrate 40 with sufficient strength without significantly impairing the solar cell module's output (a short circuit electric current, or a current in operation, in particular). This provides a tendency ensuring that the solar cell module is reliable for a long term.

Furthermore, first transparent resin 41a and second transparent resin 41 b may be identical or different in type.

Furthermore, when the above solar cell module is sealed in sealing material 41 through a heat treatment and for example first transparent resin 41 a and second transparent resin 41b are both ethylene vinyl acetate (EVA) resin, the heat treatment can be performed to heat first transparent resin 41a and second transparent resin 41b for example to a range of 100°C to 200°C.

Furthermore, back surface protection sheet 42 can be any that can protect a back surface of sealing material 41, and can for example be a conventionally used weatherproof film such as PET.

Furthermore, back surface protection sheet 42 may include a metallic film for example of aluminum or the like in order to sufficiently suppress water vapor, oxygen and/or the like from being transmitted into sealing material 41 and thus ensure long-term reliability.

Furthermore, at the solar cell module's end surface and the like, moisture-proof tape such as butyl rubber tape can be used to more completely closely attach back surface protection sheet 42 thereto.

Furthermore, one example of the present solar cell module thus fabricated may have a frame for example of aluminum alloy attached to surround the solar cell module peripherally.

Figs. 13(a) and 13(b) are schematic cross sections for illustrating another example of the method for manufacturing the solar cell module in accordance with the present invention. Hereinafter, reference will be made to Figs. 13(a) and 13(b) to describe the other example of the method for manufacturing the solar cell module in accordance with the present invention. The following will also describe as another example of the present solar cell module a solar cell module having sealed in a sealing material the solar cell with the interconnection sheet configured as shown in Figs. 8 and 9.

Initially, as shown in Fig. 13(a), back surface protection sheet 42 is alone disposed adjacent to interconnection sheet 10 of the solar cell with the interconnection sheet, and transparent substrate 40 with first transparent resin 41 a in the form of a sheet is disposed adjacent to back electrode type solar cell 30 of the solar cell with the interconnection sheet.

Subsequently, first transparent resin 41 a is pressed into contact with back electrode type solar cell 30 of the solar cell with the interconnection sheet and in that condition undergoes a heat treatment to encapsulate and thus seal the solar cell with the interconnection sheet in first transparent resin 41 a, as shown in Fig. 13(b). First transparent resin 41a thus seals the solar cell with the interconnection sheet therein, and one example of the present solar cell module is thus fabricated.

Back electrode type solar cell 30 of the solar cell module thus fabricated receives light at the photoreceptive surface, and thereby generates an electric current, which is in turn extracted through electrode for n type 34 and electrode for p type 35 of back electrode type solar cell 30 to wire for n type 12 and wire for p type 13 of interconnection sheet 10. Wire for n type 12 and wire for p type 13 of interconnection sheet 10 receive the electric current, which is in turn extracted externally through terminals 14c, 14d (see Fig. 8) of wiring 16 of interconnection sheet 10.

### Example

### <Preparing Sample>

Initially, as shown in Figs. 1 and 2, interconnection sheet 10 provided with copper patterned to have wiring 16 including wire for n type 12, wire for p type 13, first connecting wire 14a, and second connecting wire 14b, as well as outflow suppression portion 18, was fabricated on a surface of a PEN film serving as insulating base material 11.

Herein, as interconnection sheet 10, as shown in the schematic side view of Fig. 5, interconnection sheet 10 unrolled from and cut off an interconnection sheet roll of elongate interconnection sheet 10 in a predetermined length, which had wiring 16 patterned as shown in Fig. 1 and successively provided on a surface of insulating base material 11 and was rolled on core 22, was used. Note that while Fig. 1 shows alternating array portion 20 of Fig. 2 provided in two rows in first direction 50 and in two columns in second direction 51 to provide wiring 16, interconnection sheet 10 actually used in the example was provided with alternating array portion 20 of Fig. 2 in 11 rows in first direction 50 and in two columns in second direction 51 for wiring 16.

Subsequently, as shown in Fig. 6, an n type silicon substrate which had a photoreceptive surface and a back surface in a square having each side of 126 mm and having four corners removed and had a thickness of 200 µm was prepared as semiconductor substrate 31.

Then, the n type silicon substrate was provided at its back surface with n type impurity diffusion region 32 implemented as a strip-shaped n type impurity doped region doped with phosphorus and p type impurity diffusion region 33 implemented as a strip-shaped p type impurity doped region doped with boron, one by one alternately with a predetermined distance therebetween.

Subsequently, a silicon oxide film was provided through plasma CVD as passivation film 36 across the back surface of the n type silicon substrate. Then, a textured structure or a similar, uneven structure was formed across the photoreceptive surface of the n type silicon substrate. Thereafter, a silicon nitride film was provided through plasma CVD as anti-reflection film 37 on the uneven structure.

Subsequently, the silicon oxide film on the back surface of the n type silicon substrate was partially removed to form contact holes, and thereafter, as shown in Fig. 7, a strip-shaped silver electrode was formed as electrode for n type 34 on the n type impurity doped region exposed at a contact hole and a strip-shaped silver electrode was formed as electrode for p type 35 on the p type impurity doped region exposed at a contact hole to fabricate back electrode type solar cell 30.

Note that the pattern of electrode for n type 34 of back electrode type solar cell 30 was formed to match the pattern of wire for n type 12 of interconnection sheet 10, and the pattern of electrode for p type 35 of back electrode type solar cell 30 was formed to match the pattern of wire for p type 13 of interconnection sheet 10.

Subsequently, as shown in Fig. 10(a), solder paste including epoxy resin as insulating resin 17 and solder as electrically conductive adhesive 25 was applied as resin composition 17a on a surface of wire for n type 12 and a surface of wire for p type 13 of interconnection sheet 10 fabricated as described above.

Then, as shown in Fig. 10(b), 22 back electrode type solar cells 30 were provided on interconnection sheet 10 such that electrode for n type 34 of back electrode type solar cell 30 was electrically connected on wire for n type 12 of interconnection sheet 10 via electrically conductive adhesive 25 and electrode for p type 35 of back electrode type solar cell 30 was electrically connected on wire for p type 13 of interconnection sheet 10 via electrically conductive adhesive 25.

Then, as shown in Figs. 12(a) and 12(b), the solar cell with the interconnection sheet fabricated as described above was inserted between an EVA resin serving as first transparent resin 41 a provided on one surface of the glass substrate serving as transparent substrate 40 and an EVA resin serving as second transparent resin 41 b provided on one surface of back surface protection sheet 42, and the solar cell with the interconnection sheet was vacuum-pressed and thus sealed in the EVA resins serving as sealing material 41 to complete a solar cell module of the example. Vacuum press was done as follows: after evacuation was performed for 3 minutes, a pressure of 1 atmosphere was applied, and the EVA resins were held at 150°C for 6 minutes to thermally set insulating resin 17, and thereafter, furthermore, the EVA resins were heated at 150°C for 10 minutes and thus thermally set to reach a predetermined crosslinking ratio.

On this occasion, outflow of insulating resin 17 during fabrication of the solar cell module was able to be suppressed by outflow suppression portions 18.

It should be understood that the embodiment and example disclosed herein are illustrative and non-restrictive in every respect. The scope of the present invention is defined by the scope of the claims, rather than the description above, and is intended to include any modifications within the scope and meaning equivalent to the scope of the claims.

### INDUSTRIAL APPLICABILITY

The present invention is applicable to interconnection sheets, solar cells with the interconnection sheets, solar cell modules, and interconnection sheet rolls.

### REFERENCE SIGNS LIST

10: interconnection sheet, 11: insulating base material, 12: wire for n type, 13: wire for p type, 14a: first connecting wire, 14b: second connecting wire, 14c, 14d: terminal, 16: wiring, 17: insulating resin, 17a: resin composition, 18: outflow suppression portion, 20: alternating array portion, 22: core, 25: electrically conductive adhesive, 30: back electrode type solar cell, 31: semiconductor substrate, 32: n type impurity diffusion region, 33: p type impurity diffusion region, 34: electrode for n type, 35: electrode for p type, 36: passivation film, 37: anti-reflection film, 38: electrode-absent portion, 40: transparent substrate, 41: sealing material; 41a: first transparent resin, 41b: second transparent resin, 42: back surface protection sheet, 50: first direction, 51: second direction.

## Claims

1. An interconnection sheet (10) for connecting a back electrode type solar cell (30) having a semiconductor substrate (31) and an electrode for p type (35) and an electrode for n type (34) disposed at one surface of the semiconductor substrate (31), comprising:
an insulating base material (11); and
a wiring (16) provided on a surface of said insulating base material (11),
said wiring (16) having a plurality of strip-shaped wires for p type (13) each for connecting an electrode for p type (35) of the back electrode type solar cell (30), a plurality of strip-shaped wires for n type (12) each for connecting an electrode for n type (34) of the back electrode type solar cell (30), a first connecting wire (14a) electrically connected to one end of each of said wires for p type (13), and a second connecting wire (14b) electrically connected to one end of each of said electrodes for n type (34),
said wire for p type (13) and said wire for n type (12) each extending in a first direction (50),
said first connecting wire (14a) and said second connecting wire (14b) each extending in a second direction (51) different from said first direction (50),
said wire for p type (13) and said wire for n type (12) being alternately disposed in said second direction (51) with a distance therebetween to configure an alternating array portion (20),
an outflow suppression portion (18) being provided outside said alternating array portion (20).

2. The interconnection sheet (10) according to claim 1, wherein said outflow suppression portion (18) is formed of a wiring material configuring said wire for p type (13), said wire for n type (12), said first connecting wire (14a), and said second connecting wire (14b).

3. The interconnection sheet (10) according to claim 2, wherein said outflow suppression portion (18) is coupled to said first connecting wire (14a) or said second connecting wire (14b).

4. An interconnection sheet (10) for connecting a back electrode type solar cell (30) having a semiconductor substrate (31) and an electrode for p type (35) and an electrode for n type (34) disposed at one surface of the semiconductor substrate (31), comprising:
an insulating base material (11); and
a wiring (16) provided on a surface of said insulating base material (11),
said wiring (16) having a plurality of strip-shaped wires for p type (13) each for connecting an electrode for p type (35) of the back electrode type solar cell (30), a plurality of strip-shaped wires for n type (12) each for connecting an electrode for n type (34) of the back electrode type solar cell (30), a first connecting wire (14a) electrically connected to one end of each of said wires for p type (13), and a second connecting wire (14b) electrically connected to one end of each of said electrodes for n type (34),
said wire for p type (13) and said wire for n type (12) each extending in a first direction (50),
said first connecting wire (14a) and said second connecting wire (14b) each extending in a second direction (51) different from said first direction (50),
said wire for p type (13) and said wire for n type (12) being alternately disposed in said second direction (51) with a distance therebetween to configure an alternating array portion (20),
a convex portion protruding at a side provided with said wiring (16) being provided outside said alternating array portion (20).

5. A solar cell with an interconnection sheet, comprising:
an interconnection sheet (10) as recited in any of claims 1 to 4; and
a back electrode type solar cell (30) having a semiconductor substrate (31) and an electrode for p type (35) and an electrode for n type (34) disposed at one surface of the semiconductor substrate (31),
said wire for p type (13) of said interconnection sheet (10) and said electrode for p type (35) of said back electrode type solar cell (30) being electrically connected to each other,
said wire for n type (12) of said interconnection sheet (10) and said electrode for n type (34) of said back electrode type solar cell (30) being electrically connected to each other.

6. An interconnection sheet roll comprising an interconnection sheet (10) as recited in any of claims 1 to 4 rolled.

7. A solar cell with an interconnection sheet, comprising:
a back electrode type solar cell (30) having a semiconductor substrate (31) and an electrode (34, 35) disposed at one surface of the semiconductor substrate (31); and
an interconnection sheet (10) having an insulating base material (11) and a wiring (16) disposed at one surface of the insulating base material (11), said electrode (34, 35) of said back electrode type solar cell (30) and said wiring (16) of said interconnection sheet (10) being electrically connected to each other,
a bonding layer (17) being provided between said back electrode type solar cell (30) and said interconnection sheet (10),
an outflow suppression portion (18) being provided outside said bonding layer (17).

8. A solar cell module comprising a solar cell with an interconnection sheet as recited in claim 5 or 7.
